# EUROPEAN PATENT APPLICATION

(11) **EP 4 542 655 A1**
(43) Date of publication of application: **23.04.2025**
(21) Application number: 23823548.5
(22) Date of filing: 28.04.2023
(51) Int. Cl.: H01L 29/778, H01L 21/20, H01L 21/205, H01L 21/336, H01L 21/338, H01L 29/78, H01L 29/812

(54) **SEMICONDUCTOR DEVICE AND METHOD FOR MANUFACTURING SEMICONDUCTOR DEVICE**

(30) Priority: 15.06.2022 JP 2022096882
(71) Applicant: SUMITOMO ELECTRIC INDUSTRIES, LTD., Osaka-shi, Osaka 541-0041 (JP)
(72) Inventor: HIRASAKI, Takahide, Osaka-shi, Osaka 541-0041 (JP)
(74) Representative: Grünecker Patent- und Rechtsanwälte PartG mbB
(86) International application number: PCT/JP2023/016885
(87) International publication number: WO 2023/243245

(57) **Abstract**

A semiconductor device includes a first nitride semiconductor layer including gallium, and a second nitride semiconductor layer formed on the first nitride semiconductor layer and including gallium, wherein the second nitride semiconductor layer includes a plurality of third nitride semiconductor layers and a plurality of fourth nitride semiconductor layers alternately laminated on the first nitride semiconductor layer, the plurality of third nitride semiconductor layers include an impurity of a first conductivity type with a first concentration, the plurality of fourth nitride semiconductor layers include the impurity of the first conductivity type with a second concentration higher than the first concentration, and the first concentration is 1 × 10²⁰ cm⁻³ or higher.

## Description

### TECHNICAL FIELD

The present disclosure relates to semiconductor devices and methods for manufacturing semiconductor devices.

The present application is based upon and claims priority to Japanese Patent Application No. 2022-096882, filed on June 15, 2022, the entire contents of which are incorporated herein by reference.

### BACKGROUND ART

A structure in which a nitride semiconductor layer including a high concentration of an impurity is regrown has been proposed, in order to reduce a contact resistance or the like in a semiconductor device using a nitride semiconductor.

### PRIOR ART DOCUMENTS

### PATENT DOCUMENTS

Patent Document 1: Japanese Laid-Open Patent Publication No. 2008-270749
Patent Document 2: Japanese Laid-Open Patent Publication No. 2019-041113
Patent Document 3: Japanese Laid-Open Patent Publication No. 2017-059671

### NON-PATENT DOCUMENTS

NON-PATENT DOCUMENT 1: Applied Physics Express, 2 (2009) 051001

### DISCLOSURE OF THE INVENTION

A semiconductor device according to the present disclosure includes a first nitride semiconductor layer including gallium, and a second nitride semiconductor layer formed on the first nitride semiconductor layer and including gallium, wherein the second nitride semiconductor layer includes a plurality of third nitride semiconductor layers and a plurality of fourth nitride semiconductor layers alternately laminated on the first nitride semiconductor layer, the plurality of third nitride semiconductor layers include an impurity of a first conductivity type with a first concentration, the plurality of fourth nitride semiconductor layers include the impurity of the first conductivity type with a second concentration higher than the first concentration, and the first concentration is 1 × 10²⁰ cm⁻³ or higher.

### BRIEF DESCRIPTION OF THE DRAWINGS

[FIG. 1] FIG. 1 is a cross sectional view illustrating a semiconductor device according to a first embodiment.
[FIG. 2] FIG. 2 is a cross sectional view illustrating an n-type GaN layer in the first embodiment.
[FIG. 3] FIG. 3 is a diagram illustrating a relationship between a depth from front surfaces of n-type GaN layers and an impurity concentration in the first embodiment.
[FIG. 4] FIG. 4 is a cross sectional view (Part 1) illustrating a method for manufacturing the semiconductor device according to the first embodiment.
[FIG. 5] FIG. 5 is a cross sectional view (Part 2) illustrating the method for manufacturing the semiconductor device according to the first embodiment.
[FIG. 6] FIG. 6 is a cross sectional view (Part 3) illustrating the method for manufacturing the semiconductor device according to the first embodiment.
[FIG. 7] FIG. 7 is a cross sectional view (Part 4) illustrating the method for manufacturing the semiconductor device according to the first embodiment.
[FIG. 8] FIG. 8 is a cross sectional view (Part 5) illustrating the method for manufacturing the semiconductor device according to the first embodiment.
[FIG. 9] FIG. 9 is a sectional view (Part 6) illustrating the method for manufacturing the semiconductor device according to the first embodiment.
[FIG. 10] FIG. 10 is a timing chart illustrating a method of forming n-type GaN layers in the first embodiment.
[FIG. 11] FIG. 11 is a cross sectional view (Part 1) illustrating a method of forming the n-type GaN layers according to the first embodiment.
[FIG. 12] FIG. 12 is a cross sectional view (Part 2) illustrating the method of forming the n-type GaN layers according to the first embodiment.
[FIG. 13] FIG. 13 is a cross sectional view (Part 3) illustrating the method of forming the n-type GaN layers according to the first embodiment.
[FIG. 14] FIG. 14 is a cross sectional view (Part 4) illustrating the method of forming the n-type GaN layers according to the first embodiment.
[FIG. 15] FIG. 15 is a cross sectional view (Part 5) illustrating the method of forming the n-type GaN layers according to the first embodiment.
[FIG. 16] FIG. 16 is a diagram illustrating another example of the relationship between the depth from the front surfaces of the n-type GaN layers and the impurity concentration in the first embodiment.
[FIG. 17] FIG. 17 is a diagram illustrating a relationship between a continuous supply time of Ga, a droplet size L1, and a difference between a migration length L2 and the droplet size L1.
[FIG. 18] FIG. 18 is a cross sectional view (Part 1) illustrating a phenomenon in a case where the continuous supply time of Ga is too long.
[FIG. 19] FIG. 19 is a cross sectional view (Part 2) illustrating the phenomenon in the case where the continuous supply time of Ga is too long.
[FIG. 20] FIG. 20 is a cross sectional view illustrating the semiconductor device according to a second embodiment.
[FIG. 21] FIG. 21 is a cross sectional view illustrating the n-type GaN layers in the second embodiment.
[FIG. 22] FIG. 22 is a cross sectional view (Part 1) illustrating the method for manufacturing the semiconductor device according to the second embodiment.
[FIG. 23] FIG. 23 is a cross sectional view (Part 2) illustrating the method for manufacturing the semiconductor device according to the second embodiment.
[FIG. 24] FIG. 24 is a cross sectional view (Part 3) illustrating the method for manufacturing the semiconductor device according to the second embodiment.
[FIG. 25] FIG. 25 is a cross sectional view (Part) illustrating the method for manufacturing the semiconductor device according to the second embodiment.
[FIG. 26] FIG. 26 is a cross sectional view (Part 4) illustrating the method for manufacturing the semiconductor device according to the second embodiment.
[FIG. 27] FIG. 27 is a cross sectional view (Part 5) illustrating the method for manufacturing the semiconductor device according to the second embodiment.

### MODE OF CARRYING OUT THE INVENTION

### [Problem to be Solved by the Present Disclosure]

In conventional semiconductor devices, electrical characteristics may deteriorate due to precipitation of an impurity element.

One object of the present disclosure is to provide a semiconductor device and a method for manufacturing the semiconductor device, which can reduce deterioration of the electrical characteristics caused by the precipitation of the impurity element.

### [Effects of the Present Disclosure]

According to the present disclosure, it is possible to reduce the deterioration of the electrical characteristics caused by the precipitation of the impurity element.

### [Description of Embodiments of the Present Disclosure]

First, embodiments of the present disclosure will be listed and described.
[1] A semiconductor device according to one aspect of the present disclosure includes a first nitride semiconductor layer including gallium; and a second nitride semiconductor layer formed on the first nitride semiconductor layer and including gallium, wherein the second nitride semiconductor layer includes a plurality of third nitride semiconductor layers and a plurality of fourth nitride semiconductor layers alternately laminated on the first nitride semiconductor layer, the plurality of third nitride semiconductor layers include an impurity of a first conductivity type with a first concentration, the plurality of fourth nitride semiconductor layers include the impurity of the first conductivity type with a second concentration higher than the first concentration, and the first concentration is 1 × 10²⁰ cm⁻³ or higher.
   The third nitride semiconductor layer includes the impurity of the first conductivity type with the first concentration of 1 × 10²⁰ cm⁻³ or higher, and the fourth nitride semiconductor layer includes the impurity of the first conductivity type with the second concentration higher than the first concentration. Accordingly, the deterioration of the electrical characteristics caused by precipitation of the impurity element can be reduced. In addition, because the third nitride semiconductor layer and the fourth nitride semiconductor layer having the different impurity concentrations are alternately laminated, a good crystallinity can be obtained although the impurity concentration is high. Further, the third nitride semiconductor layer and the fourth nitride semiconductor layer can be formed by physical vapor deposition, for example. That is, the third nitride semiconductor layer and the fourth nitride semiconductor layer having the good crystallinity can be formed using an existing film forming apparatus.
[2] In [1] above, the plurality of third nitride semiconductor layers and the plurality of fourth nitride semiconductor layers may be laminated with a period of 8 nm or less. As this period becomes smaller, it becomes more likely that the second nitride semiconductor layer having the good crystallinity can be obtained.
[3] In [1] or [2] above, a difference between the first concentration and the second concentration may be 1 × 10²⁰ cm⁻³ or higher and 7 × 10²⁰ cm⁻³ or lower. If the concentration difference is too small or too large, it may be difficult to obtain the second nitride semiconductor layer with a good crystallinity.
[4] In any of [1] to [3] above, the impurity may be germanium or silicon. When the impurity is germanium or silicon, a low electrical resistance can easily be obtained in the second nitride semiconductor layer.
[5] In any one of [1] to [4] above, an ohmic electrode may be formed on the second nitride semiconductor layer. In this case, a low electrical resistance can be obtained between the first nitride semiconductor layer and the ohmic electrode.
[6] In any one of [1] to [5] above, a surface of the first nitride semiconductor layer in contact with a lower surface of the second nitride semiconductor layer may be a nitrogen polar surface. In this case, a low resistance can easily be obtained.
[7] In [6] above, the first nitride semiconductor layer may include a barrier layer, and a channel layer provided above the barrier layer. In this case, a low resistance can easily be obtained.
[8] In [6] or [7] above, an insulating layer may be formed on the first nitride semiconductor layer, the insulating layer may include an opening exposing the first nitride semiconductor layer, and the second nitride semiconductor layer may be formed inside the opening. In this case, it is easy to reduce the resistance while protecting the first nitride semiconductor layer with the insulating layer.
[9] In any one of [1] to [5] above, a surface of the first nitride semiconductor layer in contact with a lower surface of the second nitride semiconductor layer may be a gallium polar surface. In this case, it is easy to grow the first nitride semiconductor layer, and an upper surface of the first nitride semiconductor layer can easily exhibit a good etching resistance.
[10] In [9] above, the first nitride semiconductor layer may include a channel layer, and a barrier layer provided above the channel layer. In this case, it is easy to grow the first nitride semiconductor layer, and the upper surface of the first nitride semiconductor layer can easily exhibit a good etching resistance.
[11] In [9] or [10] above, the first nitride semiconductor layer may be formed with a recess, and the second nitride semiconductor layer may be formed inside the recess. In this case, a low resistance can easily be obtained.
[12] A method for manufacturing a semiconductor device according to another aspect of the present disclosure includes the steps of forming, on a first nitride semiconductor layer including gallium, a second nitride semiconductor layer including gallium by physical vapor deposition, wherein the step of forming the second nitride semiconductor layer includes repeating the steps of forming a third nitride semiconductor layer including an impurity of a first conductivity type with a first concentration, and forming droplets of an alloy of gallium and the impurity on a surface of the third nitride semiconductor layer, and forming a fourth nitride semiconductor layer including the impurity of the first conductivity type with a second concentration higher than the first concentration, by evaporating a portion of the gallium from the droplets and nitriding another portion of the gallium in the droplets while incorporating the impurity in the droplet.
   When forming the second nitride semiconductor layer by the physical vapor deposition, the forming of the third nitride semiconductor layer and the forming of the fourth nitride semiconductor layer are repeated. When forming the third nitride semiconductor layer, the droplets of the alloy of gallium and the impurity are formed on the surface of the third nitride semiconductor layer, and when forming the fourth nitride semiconductor layer, a portion of the gallium is evaporated from the droplets, and the other portion of the gallium in the droplets is nitrided while incorporating the impurity in the droplets. Accordingly, even in a case where the third nitride semiconductor layer includes the impurity of the first conductivity type with a high concentration of 1 × 10²⁰ cm⁻³ or higher for example, the third nitride semiconductor layer and the fourth nitride semiconductor layer can have a good crystallinity. For this reason, residual impurity precipitation can be suppressed at the surface of the second nitride semiconductor layer, and a deterioration of electrical characteristics caused by the precipitation can be reduced.
[13] In [12] above, the step of forming the fourth nitride semiconductor layer may eliminate the droplets. If the droplets remain, the crystallinity of the fourth nitride semiconductor layer may deteriorate.
[14] In [12] or [13] above, a duration of the step of forming the fourth nitride semiconductor layer is longer than a duration of the step of forming the third nitride semiconductor layer. In this case, the droplets can easily be eliminated.
[15] In any one of [12] to [14] above, the third nitride semiconductor layer and the fourth nitride semiconductor layer may be formed inside a chamber, and in the steps of forming of the third nitride semiconductor layer and forming of the fourth nitride semiconductor layer, a saturation vapor pressure of gallium may be lower than a pressure inside the chamber at a temperature inside the chamber. In this case, the droplets including the gallium are likely formed stably.
[16] In any one of [12] to [15] above, the first nitride semiconductor layer may be formed on a substrate, and a temperature of the substrate when forming the third nitride semiconductor layer and the fourth nitride semiconductor layer may be 200°C or higher and 650°C or lower. If the temperature of the substrate is too low, it is difficult to form the third nitride semiconductor layer and the fourth nitride semiconductor layer, and if the temperature of the substrate is too high, the first nitride semiconductor layer or the like which is already formed may become damaged.

### [Details of Embodiments of the Present Disclosure]

Hereinafter, embodiments of the present disclosure will be described in detail, but the present disclosure is not limited these embodiments. In the specification and the drawings, constituent elements having substantially the same functional configuration are designated by the same reference numerals, and a redundant description thereof may be omitted.

### (First Embodiment)

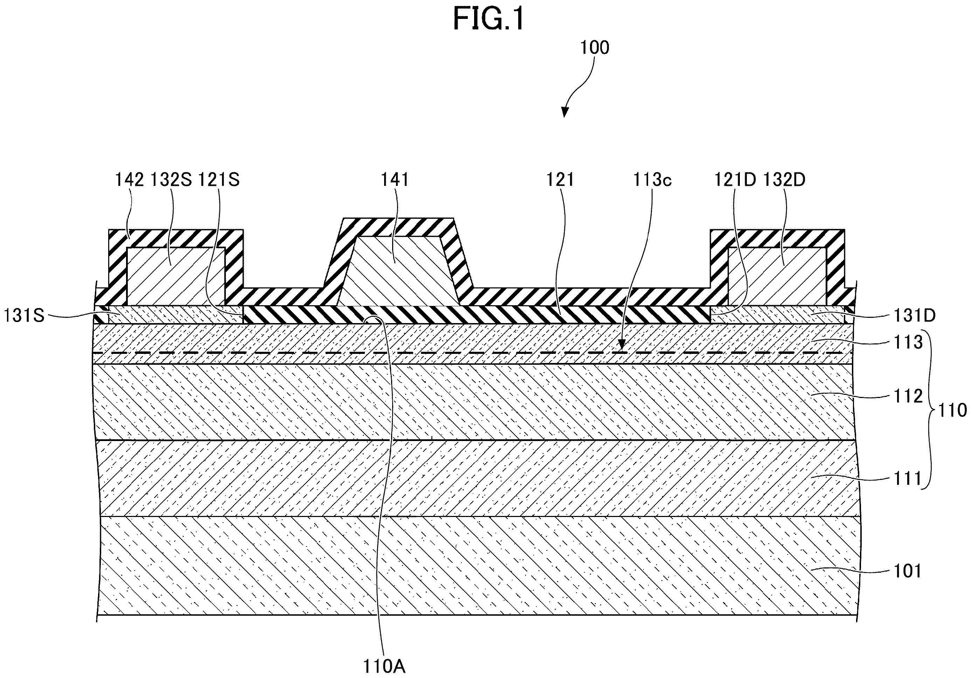

First, a first embodiment will be described. The first embodiment relates to a semiconductor device including a GaN-based high electron mobility transistor (HEMT). FIG. 1 is a cross sectional view illustrating the semiconductor device according to the first embodiment.

As illustrated in FIG. 1, a semiconductor device 100 according to the first embodiment mainly includes a substrate 101, a nitride semiconductor layer 110, an insulating layer 121, an n-type gallium nitride (GaN) layer 131S, an n-type GaN layer 131D, a gate electrode 141, a source electrode 132S, a drain electrode 132D, and an insulating layer 142.

The substrate 101 is a substrate for growing a GaN-based semiconductor, for example, and is a semiinsulating silicon carbide (SiC) substrate, for example. In a case where the substrate 101 is the SiC substrate, a front surface of the substrate 101 is a carbon (C) polar surface. In the case where the front surface of the substrate 101 is the C polar surface, the nitride semiconductor layer 110 can undergo crystal growth using a nitrogen (N) polar surface as a growth surface. A sapphire substrate may be used as the substrate for growing the GaN-based semiconductor. The substrate 101 does not have to be the substrate for crystal growth, and in this case, the nitride semiconductor layer 110 may be grown on another substrate, and after removing this other substrate from the nitride semiconductor layer 110, the substrate 101 may be bonded to the nitride semiconductor layer 110. In this case, a semiinsulating substrate made of various materials, such as a sapphire substrate, a silicon (Si) substrate, a SiC substrate, an aluminum nitride (AlN) substrate, a sintered body, or the like, for example, may be used as the substrate 101.

The nitride semiconductor layer 110 includes a buffer layer 111, a barrier layer 112, and a channel layer 113. The nitride semiconductor layer 110 is an example of a first nitride semiconductor layer.

The buffer layer 111 is an AlN layer, for example. A thickness of the AlN layer is 5 nm or greater and 100 nm or less, for example. The buffer layer 111 may include an AlN layer, and a GaN layer or an aluminum gallium nitride (AlGaN) layer on the AlN layer. A thickness of the GaN layer or the AlGaN layer is 300 nm or greater and 2000 nm or less, for example.

The barrier layer 112 is an AlGaN layer, for example. A band gap of the barrier layer 112 is larger than a band gap of the channel layer 113 which will be described later. A thickness of the barrier layer 112 is in a range of 5 nm or greater and 50 nm or less, for example, and is 30 nm in one embodiment. In a case where the barrier layer 112 is a AlₓGa₁₋ₓN layer, an Al composition x thereof is 0.15 or greater and 0.55 or less, for example, and is 0.35 in one embodiment. A conductivity type of the barrier layer 112 is an n-type or undoped (i-type), for example. An indium aluminum nitride (InAlN) layer or an indium aluminum gallium nitride (InAlGaN) layer may be used in place of the AlGaN layer.

The channel layer 113 is a GaN layer, for example. The band gap of the channel layer 113 is smaller than the band gap of the barrier layer 112. A thickness of the channel layer 113 is in a range of 5 nm or greater and 30 nm or less, for example, and is 9 nm in one embodiment. A strain is generated between the channel layer 113 and the barrier layer 112 due to a difference in lattice constants thereof, and this strain induces a piezoelectric charge at an interface between the two layers. Hence, a two-dimensional electron gas (2DEG) is generated in a region of the channel layer 113 closer to the barrier layer 112, thereby forming a channel region 113c. A conductivity type of the channel layer 113 is the n-type or undoped (i-type), for example. A front surface of the channel layer 113 constitutes a front surface 110A of the nitride semiconductor layer 110. A spacer layer may be formed between the barrier layer 112 and the channel layer 113. The spacer layer is an AlN layer, for example. A thicknesses of the spacer layer is in a range of 0.5 nm or greater and 3.0 nm or less, for example, and is 1.0 nm in one embodiment.

On the C polar surface of the SiC substrate, the buffer layer 111, the barrier layer 112, and the channel layer 113 undergo crystal growth using the N polar surface as the growth surface. Accordingly, front surfaces of the buffer layer 111, the barrier layer 112, and the channel layer 113 opposite to back surfaces thereof facing the substrate 101 become N polar surfaces, and the back surfaces thereof facing the substrate 101 become gallium (Ga) polar surfaces.

The insulating layer 121 makes contact with the front surface 110A of the nitride semiconductor layer 110. The insulating layer 121 is a silicon nitride (SiN) layer, for example. Openings 121S and 121D are formed in the insulating layer 121. A portion of the nitride semiconductor layer 110 is exposed via the opening 121S, and another portion of the nitride semiconductor layer 110 is exposed via the opening 121D.

The n-type GaN layer 131S is formed on the nitride semiconductor layer 110 inside the opening 121S. The n-type GaN layer 131D is formed on the nitride semiconductor layer 110 inside the opening 121D. The n-type GaN layers 131S and 131D include germanium (Ge) or Si as an n-type impurity. The n-type GaN layers 131S and 131D are examples of a second nitride semiconductor layer.

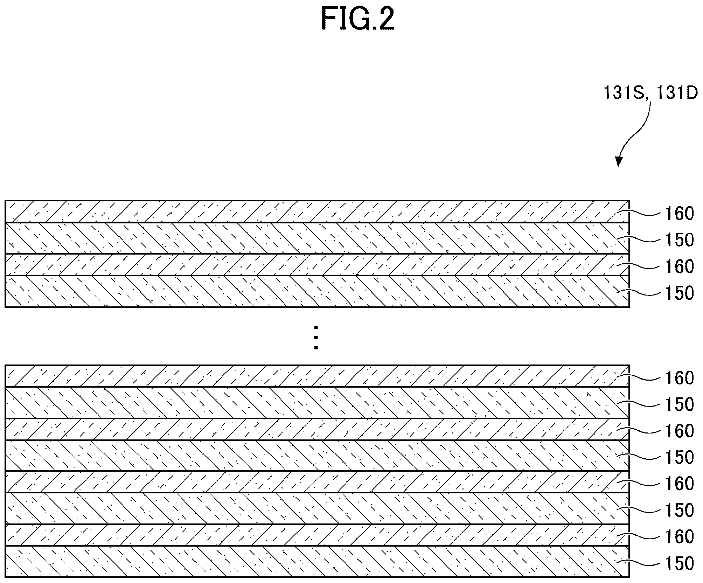

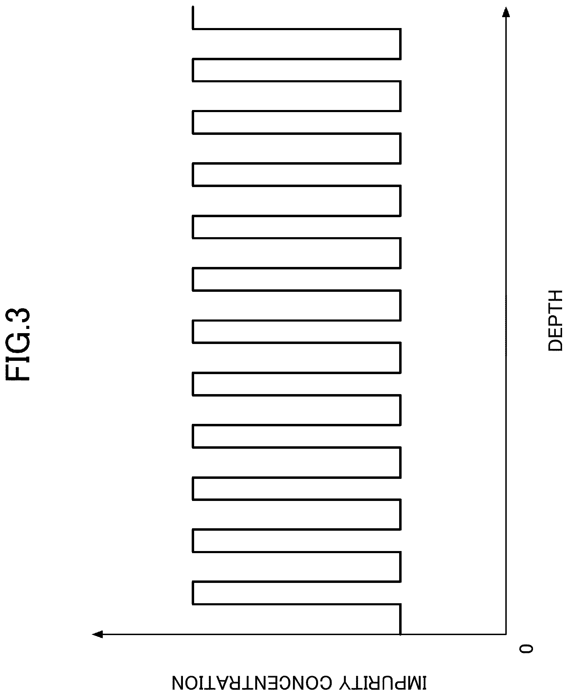

Next, the n-type GaN layers 131S and 131D will be described in detail. FIG. 2 is a cross sectional view illustrating the n-type GaN layers 131S and 131D in the first embodiment. FIG. 3 is a diagram illustrating a relationship between a depth from front surfaces of the n-type GaN layers 131S and 131D and an impurity concentration in the first embodiment.

As illustrated in FIG. 2, the n-type GaN layers 131S and 131D, which are examples of the second nitride semiconductor layer, include a plurality of n-type GaN layers 150 and a plurality of n-type GaN layers 160. The n-type GaN layers 150 and 160 are alternately laminated on the nitride semiconductor layer 110. For example, the n-type GaN layers 150 and 160 are laminated on the nitride semiconductor layer 110 with a period of 8 nm or less. The n-type GaN layer 150 includes an n-type impurity with a first concentration of 1 × 10²⁰ cm⁻³ or higher. The n-type GaN layer 150 includes the n-type impurity with the first concentration of 3 × 10²⁰ cm⁻³, for example, and the n-type GaN layer 160 includes an n-type impurity with a second concentration higher than the first concentration, such as 9 × 10²⁰ cm⁻³, for example. In this example, a difference between the first concentration and the second concentration is 6 × 10²⁰ cm⁻³. For this reason, as illustrated in FIG. 3, in the n-type GaN layers 131S and 131D, the impurity concentration periodically varies in a depth direction. The n-type GaN layers 131S and 131D have the n-type GaN layer 150 as a lowermost layer and the n-type GaN layer 160 as an uppermost layer, for example. The n-type GaN layer 150 is an example of a third nitride semiconductor layer, and the n-type GaN layer 160 is an example of a fourth nitride semiconductor layer.

As illustrated in FIG. 1, the source electrode 132S is formed on the n-type GaN layer 131S, and the drain electrode 132D is formed on the n-type GaN layer 131D. The source electrode 132S and the drain electrode 132D include a laminated structure in which a tantalum (Ta) film, an Al film, and a Ta film are laminated in this order, for example. The source electrode 132S and the drain electrode 132D may include a laminated structure in which a titanium (Ti) film, an Al film, and a Ti film are laminated in this order, or a laminated structure in which a nickel (Ni) film and a gold (Au) film are laminated in this order, for example. The source electrode 132S and the drain electrode 132D are examples of an ohmic electrode.

The gate electrode 141 is formed on the insulating layer 121 between the source electrode 132S and the drain electrode 132D. The gate electrode 141 includes a laminated structure in which a Ni film, a palladium (Pd) film, and an Au film are laminated in this order, for example. The insulating layer 142 is formed on the insulating layer 121, and covers the gate electrode 141.

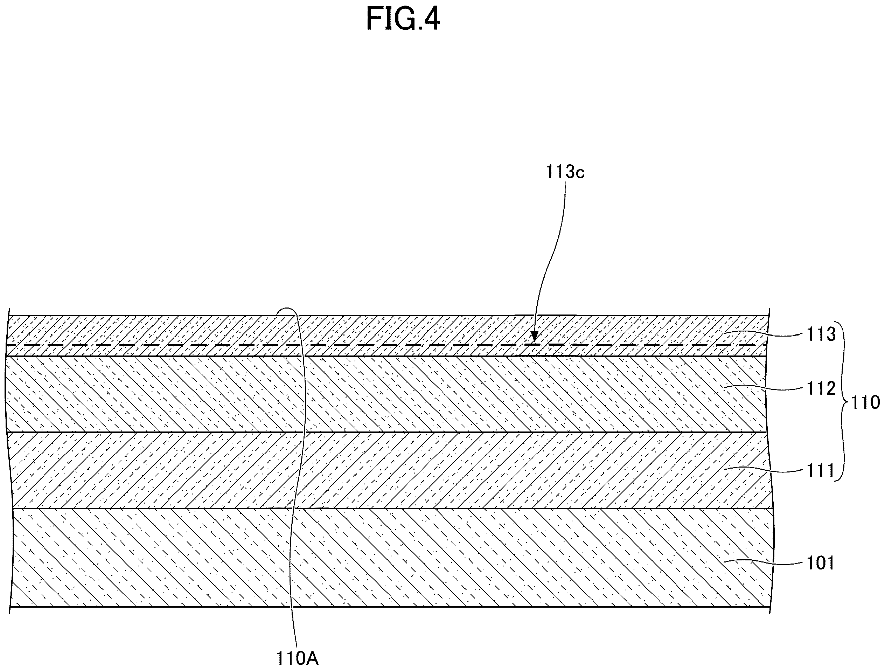

Next, a method for manufacturing the semiconductor device 100 according to the first embodiment will be described. FIG. 4 through FIG. 9 are cross sectional views illustrating the method for manufacturing the semiconductor device according to the first embodiment.

First, as illustrated in FIG. 4, the nitride semiconductor layer 110 is formed on the substrate 101 by metal organic chemical vapor deposition (MOCVD), for example. When forming the nitride semiconductor layer 110, the buffer layer 111, the barrier layer 112, and the channel layer 113 are formed in this order. The strain is generated between the channel layer 113 and the barrier layer 112 due to the difference in the lattice constants thereof, and this strain induces the piezoelectric charge at the interface between the two layers. Hence, the 2DEG is formed in the region of the channel layer 113 closer to the barrier layer 112, thereby forming the channel region 113c.

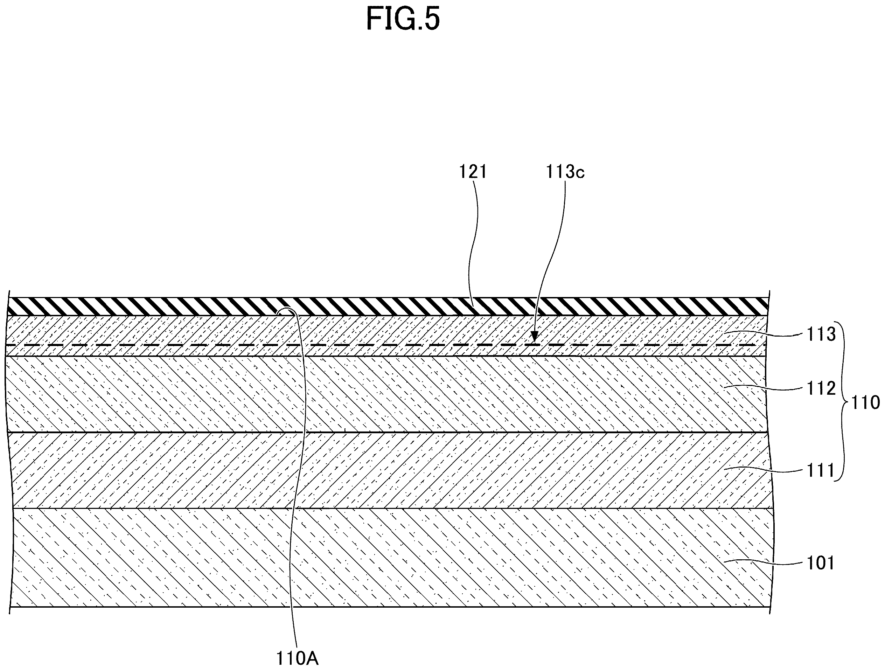

Next, as illustrated in FIG. 5, the insulating layer 121, in contact with the front surface 110A of the nitride semiconductor layer 110, is formed. The insulating layer 121 can be formed by low pressure CVD (LPCVD), for example. The insulating layer 121 may be formed continuously on the buffer layer 111, the barrier layer 112, and the channel layer 113 by MOCVD, for example, without exposing the front surface of the channel layer 113 to atmosphere.

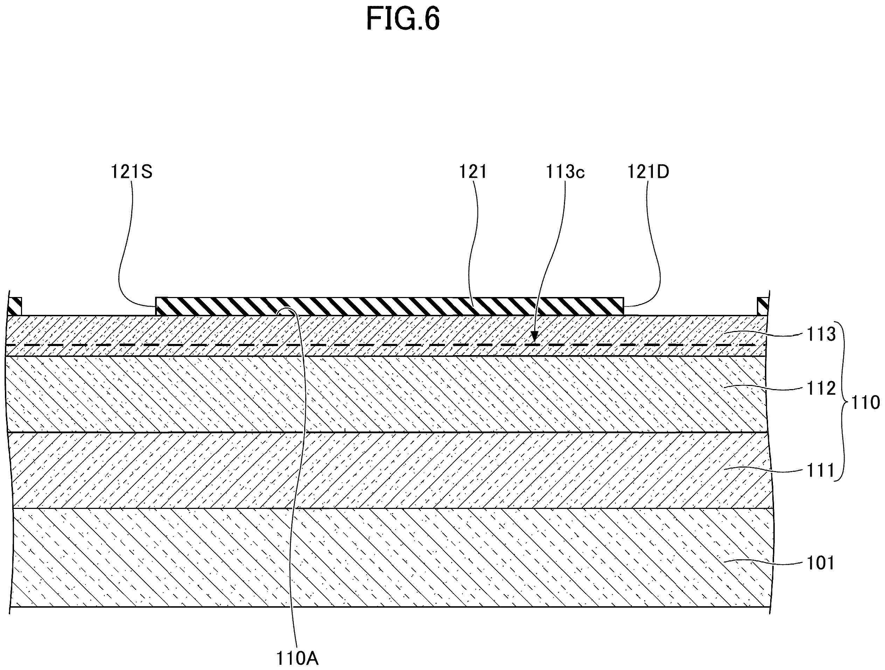

Next, as illustrated in FIG. 6, the openings 121S and 121D are formed in the insulating layer 121. The openings 121S and 121D can be formed by reactive ion etching (RIE) using a resist pattern (not illustrated) as a mask, for example. The RIE uses a fluorine-based gas as a reactive gas, for example.

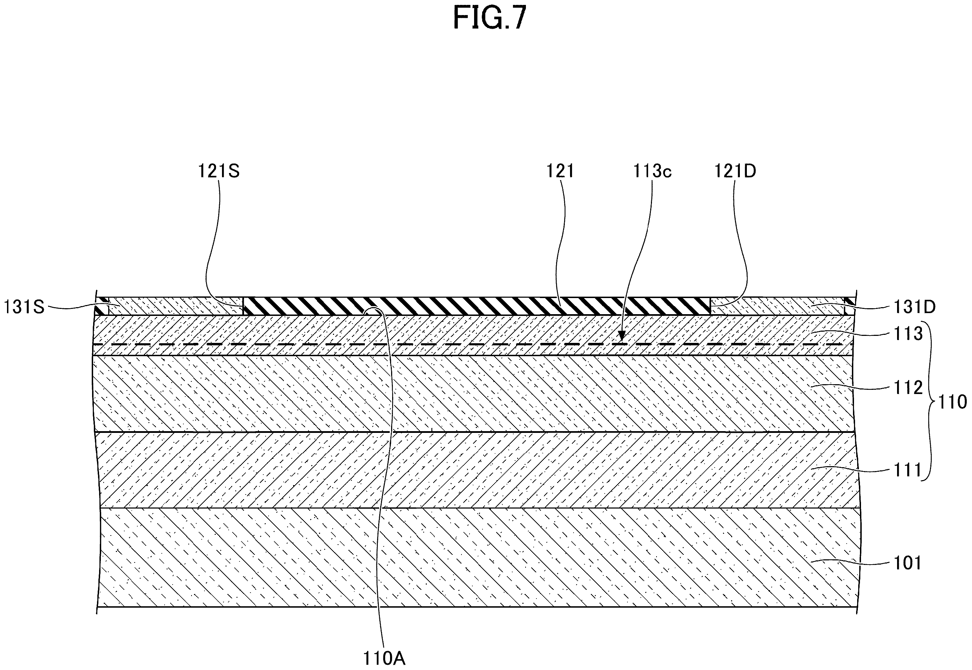

Next, as illustrated in FIG. 7, the n-type GaN layer 131S is formed on the nitride semiconductor layer 110 inside the opening 121S, and the n-type GaN layer 131D is formed on the nitride semiconductor layer 110 inside the opening 121D. Upper surfaces of the n-type GaN layers 131S and 131D may coincide with an upper surface of the insulating layer 121, or may not coincide with the upper surface of the insulating layer 121. The n-type GaN layers 131S and 131D can be formed by physical vapor deposition (PVD), such as vapor deposition, sputtering, molecular beam epitaxy (MBE), or the like, for example. When forming the n-type GaN layers 131S and 131D, a film deposition is performed using a growth mask (not illustrated) having openings formed in regions where the n-type GaN layers 131S and 131D are to be formed, and the growth mask is thereafter removed together with an n-type GaN layer (not illustrated) formed thereon, for example. That is, a lift-off is performed. Details of the method of forming the n-type GaN layers 131S and 131D will be described later.

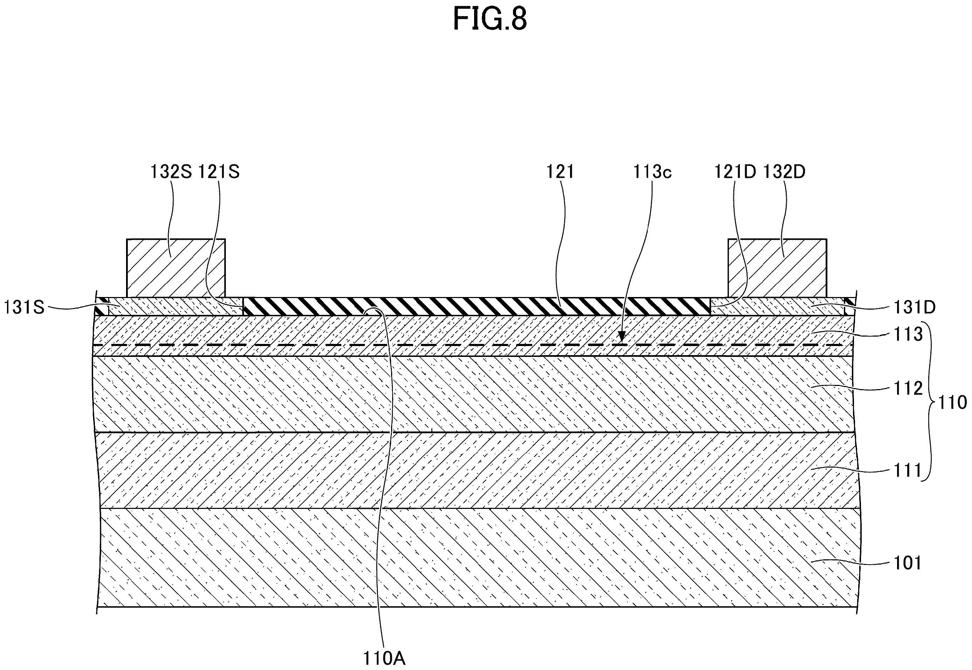

Next, as illustrated in FIG. 8, the source electrode 132S is formed on the n-type GaN layer 131S, and drain electrode 132D is formed on the n-type GaN layer 131D. When forming the source electrode 132S and the drain electrode 132D, a metal layer (not illustrated) constituting the source electrode 132S and the drain electrode 132D is formed first. When forming the metal layer, a film deposition is performed using a growth mask (not illustrated) having openings formed in regions where the metal layer is to be formed, and the growth mask is thereafter removed together with the metal layer (not illustrated) formed thereon, for example. That is, a lift-off is performed.

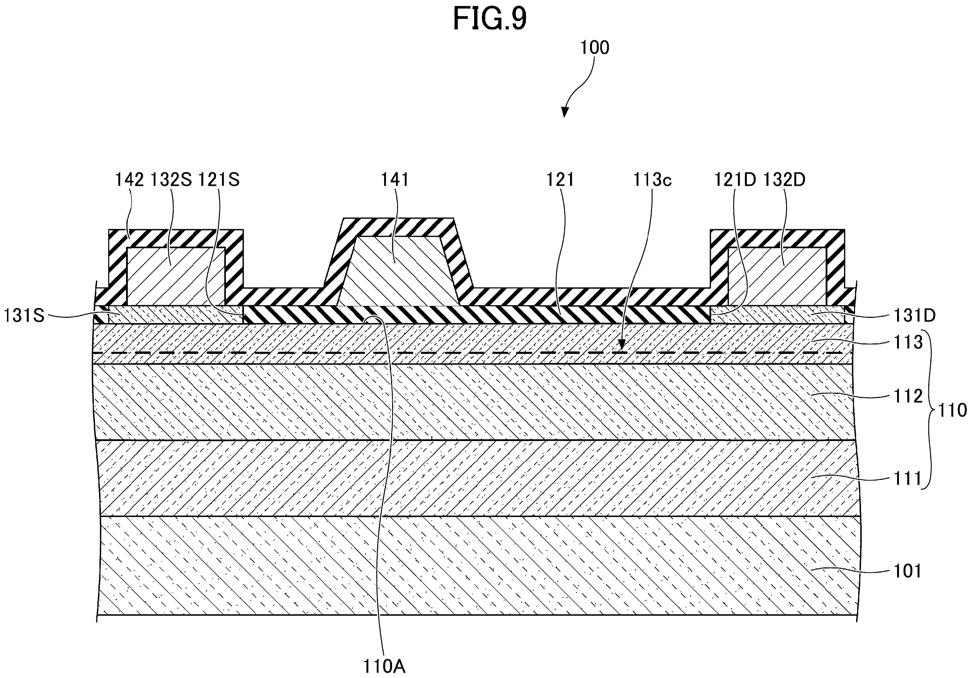

Next, as illustrated in FIG. 9, the gate electrode 141 is formed on the insulating layer 121 between the source electrode 132S and the drain electrode 132D. When forming the gate electrode 141, a metal layer is formed using a growth mask (not illustrated) having an opening formed in a region where the gate electrode 141 is to be formed, and the growth mask is thereafter removed together with the metal layer (not illustrated) formed thereon, for example. That is, a lift-off is performed. After forming the gate electrode 141, the insulating layer 142 is formed on the insulating layer 121 by plasma CVD, for example, so as to cover the gate electrode 141 with the insulating layer 142.

The semiconductor device 100 can be manufactured in the manner described above.

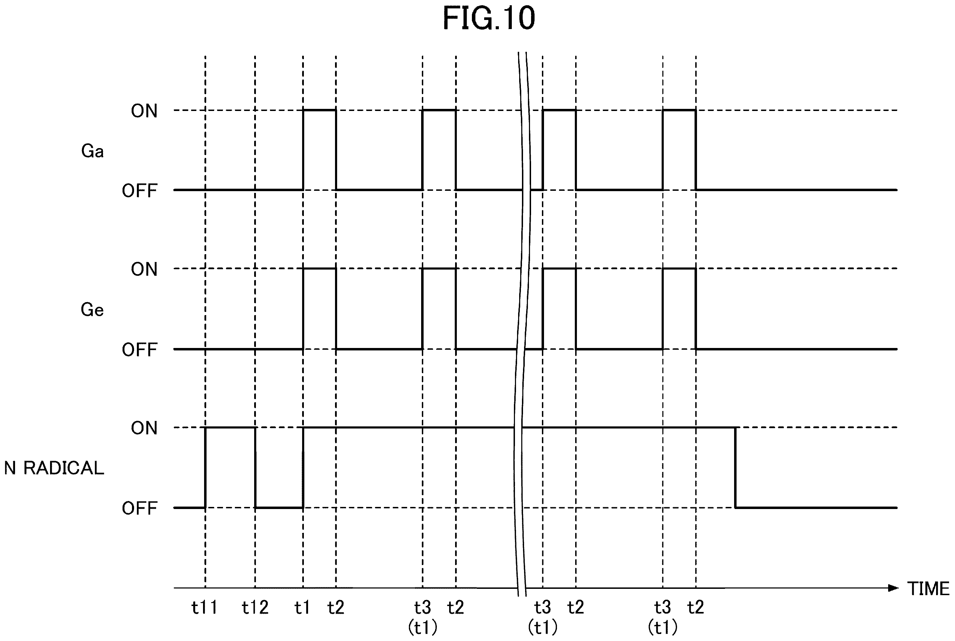

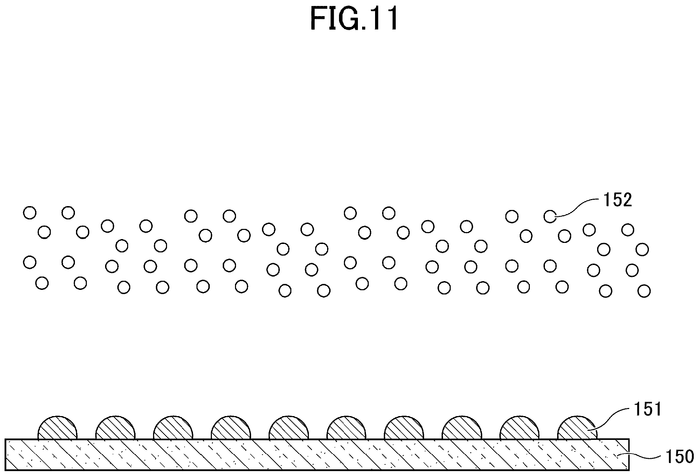

Next, a method of forming the n-type GaN layers 131S and 131D will be described. It is assumed in this example that the n-type GaN layers 131S and 131D are formed by sputtering. Further, it is assumed that Ge is used as the n-type impurity. FIG. 10 is a timing chart illustrating the method of forming the n-type GaN layers 131S and 131D. FIG. 10 illustrates whether Ga, Ge, and N radicals are supplied to the nitride semiconductor layer 110 when forming the n-type GaN layers 131S and 131D. In FIG. 10, "ON" indicates that there is a supply, and "OFF" indicates that there is no supply. FIG. 11 through FIG. 15 are cross sectional views illustrating the method of forming the n-type GaN layers 131S and 131D.

After the substrate 101 formed with the nitride semiconductor layer 110 or the like is placed inside a deposition chamber, a temperature inside the deposition chamber is set to a predetermined temperature and a pressure inside the deposition chamber is set to a predetermined pressure. The predetermined temperature and the predetermined pressure are selected so that a saturation vapor pressure of Ga is lower than the predetermined pressure at the predetermined temperature. For example, the predetermined temperature is 600°C, and the predetermined pressure is higher than the saturation vapor pressure of Ga at 600°C. A saturation vapor pressure of Ge is lower than the saturation vapor pressure of Ga.

When the temperature and the pressure inside the chamber stabilize to the predetermined temperature and the predetermined pressure, respectively, the supply of the N radicals 152 to the nitride semiconductor layer 110 is started at a time t11, and the supply of the N radicals 152 is stopped at a time t12. The front surface of the nitride semiconductor layer 110 is cleaned by the supply of the N radicals 152 from the time t11 to the time t12. For example, the N radicals 152 are generated by inductively coupled plasma (ICP).

At a subsequent time t1, the supply of Ga, Ge, and the N radicals 152 to the nitride semiconductor layer 110 is started, and at a subsequent time t2, the supply of Ga and Ge is stopped while continuing the supply of the N radicals 152. As illustrated in FIG. 11, the n-type GaN layer 150 is formed by the supply of Ga, Ge, and the N radicals 152 from time t1 to time t2. Further, simultaneously with the formation of the n-type GaN layer 150, droplets 151 of an alloy of Ga and Ge are formed on the front surface of the n-type GaN layer 150. For example, Ga is supplied by radio frequency (RF) sputtering, and Ge is supplied by direct current (DC) pulse sputtering. A time period from the time t1 to the time t2 is 10 seconds or longer and 30 seconds or shorter, and preferably 20 seconds or longer and 30 seconds or shorter, for example.

For example, a number density of the droplets 151 is approximately 6.1 × 10⁴ cm⁻², an average diameter of the droplets 151 is approximately 300 nm, and a height of the droplets 151 is approximately 57 nm.

At a subsequent time t3, the supply of Ga and Ge is started while continuing the supply of the N radicals 152, similar to the time t1.

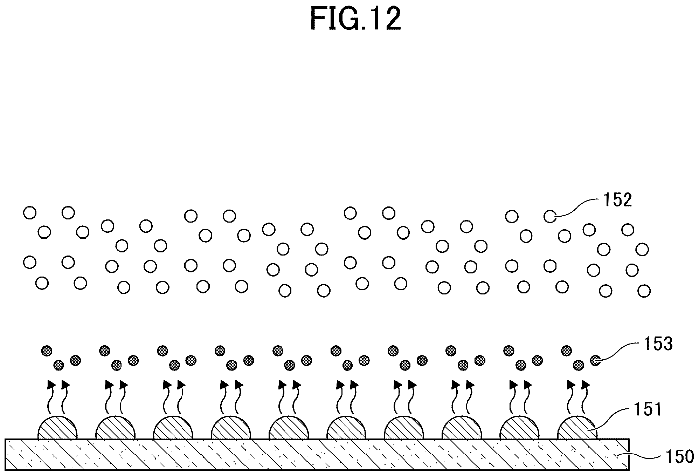

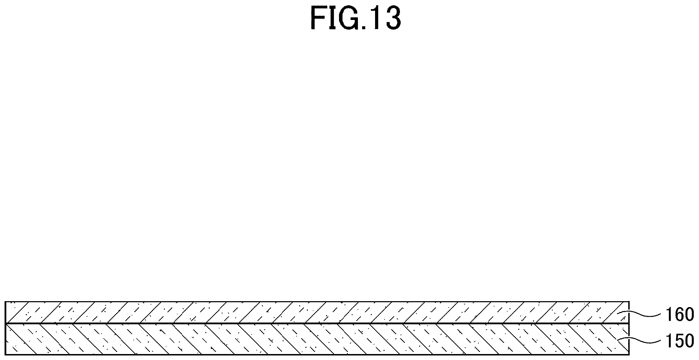

Because the supply of Ga is stopped during a time period from the time t2 to the time t3, a portion of Ga evaporates from the droplet 151 as a gas Ga 153, as illustrated in FIG. 12. On the other hand, although the supply of Ge is also stopped, Ge remains in the droplet 151 because the saturation vapor pressure of Ge is lower than the saturation vapor pressure of Ga. Further, because the supply of the N radicals 152 continues, Ga in the droplet 151 incorporates Ge while being nitrided. As a result, as illustrated in FIG. 13, the n-type GaN layer 160 is formed. When forming the n-type GaN layer 160, a portion of Ga evaporates as the gas Ga 153 while Ge remains in the droplet 151, and a ratio of Ge with respect to a total amount of Ga and Ge in the droplet 151 becomes higher than a ratio of Ge with respect to a total amount of Ga and Ge in the n-type GaN layer 150. Accordingly, the n-type GaN layer 160 formed of the droplets 151 from which Ga evaporated includes a higher concentration of Ge than the n-type GaN layer 150. The time period from the time t2 to the time t3 is 15 seconds or longer and 120 seconds or shorter, for example.

In addition, even if the ratio of Ge in the droplet 151 increases with the evaporation of Ga, Ge does not agglomerate to such an extent that a critical nucleus is formed. Even if a fine single Ge were temporarily generated, the single Ge would decompose before growing to the critical nucleus, because the supply of Ge is also stopped during the time period from the time t2 to the time t3. For this reason, no Ge precipitation is generated also when forming the n-type GaN layer 160.

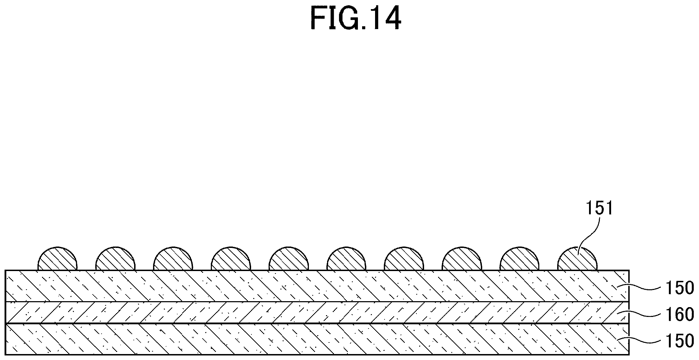

At the subsequent time t2, the supply of Ga and Ge is stopped while continuing the supply of the N radicals. As illustrated in FIG. 14, by the supply of Ga, Ge, and the N radicals from time t3 (t1) to the time t2, an n-type GaN layer 150 is newly formed, and droplets 151 of the alloy of Ga and Ge are formed on the front surface of the n-type GaN layer 150.

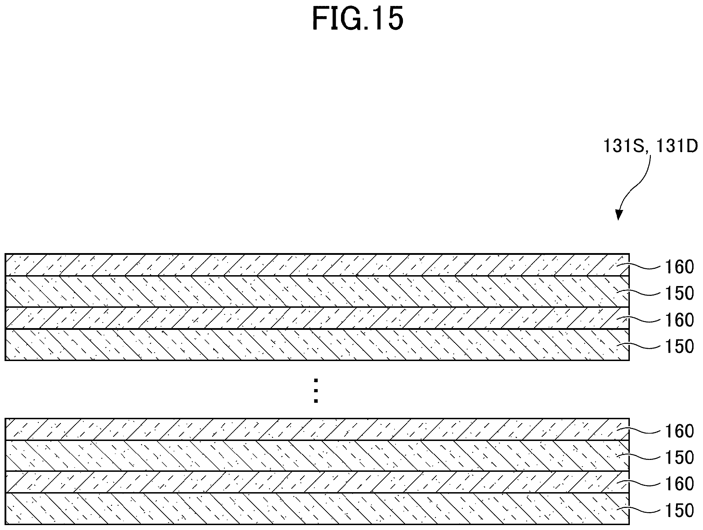

Thereafter, the processes from the time t1 to the time t3 are repeatedly performed. As a result, as illustrated in FIG. 15, the n-type GaN layers 131S and 131D in which the n-type GaN layers 150 and 160 are alternately laminated are formed. Each of the n-type GaN layers 150 and 160 may make direct contact with the nitride semiconductor layer 110, for example.

In the semiconductor device 100 according to the first embodiment, the n-type GaN layer 150 includes the n-type impurity, such as Ge or the like, with the first concentration of 1 × 10²⁰ cm⁻³ or higher, and the n-type GaN layer 160 includes an n-type impurity, such as Ge or the like, with the second concentration higher than the first concentration. Accordingly, electrical resistances of the n-type GaN layers 131S and 131D can be sufficiently reduced. The thicknesses of the n-type GaN layers 131S and 131D are preferably 20 nm or greater and 100 nm or less, more preferably 30 nm or greater and 100 nm or less, and still more preferably 40 nm or greater and 100 nm or less.

In addition, because the n-type GaN layers 150 and 160 having different n-type impurity concentrations are alternately laminated, a good crystallinity can be obtained although the n-type impurity concentrations are high. Moreover, the n-type GaN layers 150 and 160 can be formed by PVD at a temperature at which a damage to the nitride semiconductor layer 110 formed before the formation of these two layers is suppressed. Further, the droplets 151 are formed when forming the n-type GaN layer 150, and the n-type GaN layer 160 is formed using these droplets 151. Accordingly, Ge precipitation is less likely to remain on outermost surfaces of the n-type GaN layers 131S and 131D. In a case where a GaN layer including a high concentration of Ge is formed by pulse sputtering, the Ge precipitation is likely to remain on the front surface of the GaN layer. However, according to the present embodiment, residual Ge precipitation can be suppressed, and a deterioration of electrical characteristics caused by the precipitation can be reduced. By lowering the formation temperature of the n-type GaN layers 150 and 160, the effects of improving throughput and reducing greenhouse gas emissions can also be obtained.

In the first embodiment, the surface of the nitride semiconductor layer 110 in contact with lower surfaces of the n-type GaN layers 131S and 131D are N polar surfaces, and the channel layer 113 is located above the barrier layer 112. For this reason, distances between the channel region 113c and the source and drain electrodes 132S and 132D can easily be reduced, and the resistance can easily be reduced. In addition, because the n-type GaN layers 131S and 131D are formed inside the openings 121S and 121D formed in the insulating layer 121, respectively, it is easy to achieve the low resistance while protecting the nitride semiconductor layer 110 by the insulating layer 121.

The period of the n-type GaN layers 150 and 160 in the thickness direction is preferably 8 nm or less, more preferably 6 nm or less, and still more preferably 4 nm or less. As the period of the n-type GaN layers 150 and 160 becomes smaller, the n-type GaN layers 131S and 131D are more likely to have a good crystallinity. For example, in a case where the n-type GaN layer 150 is too thick, large droplets 151 are formed when forming the n-type GaN layer 150. The n-type GaN layer 160 is formed through migration of Ga atoms in the droplets 151 on the front surface of the n-type GaN layer 150, but in the case where the large droplets 151 are formed, nitridation of Ga may occur at a stage where the migration of the Ga atoms does not sufficiently occur. In this case, it may be difficult to obtain a good n-type GaN layer 160.

The difference between the first concentration and the second concentration is preferably 1 × 10²⁰ cm⁻³ or higher and 7 × 10²⁰ cm⁻³ or lower, more preferably 2 × 10²⁰ cm⁻³ or higher and 6 × 10²⁰ cm⁻³ or lower, and still more preferably 3 × 10²⁰ cm⁻³ or higher and 5 × 10²⁰ cm⁻³ or lower. If the concentration difference is too small or too large, it may be difficult to obtain the n-type GaN layers 131S and 131D with a good crystallinity.

The n-type impurity is not particularly limited, but when Ge or Si is used, a low electrical resistance can easily be obtained in the n-type GaN layers 150 and 160.

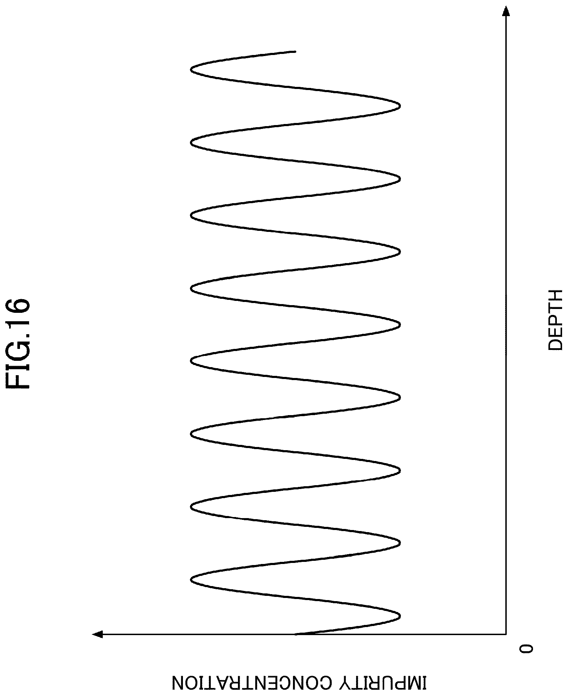

The concentration of the impurity, such as Ge, Si, or the like, included in the n-type GaN layers 131S and 131D can be measured by secondary ion mass spectrometry (SIMS). Although the impurity concentration varies in a rectangular wave shape in FIG. 3, a measurement result of the impurity concentration may vary in a sinusoidal wave shape as illustrated in FIG. 16. In this case, ranges of the n-type GaN layers 150 and 160 can be specified by approximating an impurity concentration profile by the rectangular wave shape.

When forming the n-type GaN layer 160, the droplets 151 formed on the front surface of the n-type GaN layer 150 are preferably eliminated by evaporation, nitridation, or the like. This is because, if the droplets 151 remain, the crystallinity of the n-type GaN layer 160 may deteriorate. A portion of Ga in the droplet 151 may be incorporated into the n-type GaN layer 150.

The time period from the time t2 to the time t3 is preferably longer than the time period from the time t1 to the time t2. That is, the time in which the n-type GaN layer 150 is formed is preferably longer than the time in which the n-type GaN layer 160 is formed by thereafter continuing the supply of the N radicals 152. This is because the droplets 151 can easily be eliminated.

A temperature of the substrate 101 when forming the n-type GaN layers 150 and 160 is preferably 200°C or higher and 650°C or lower, more preferably 250°C or higher and 600°C or lower, and still more preferably 300°C or higher and 550°C or lower. This is because, if the temperature of the substrate 101 is too low, it becomes difficult to form the n-type GaN layers 150 and 160, and if the temperature is too high, the nitride semiconductor layer 110 or the like which are already formed may become damaged.

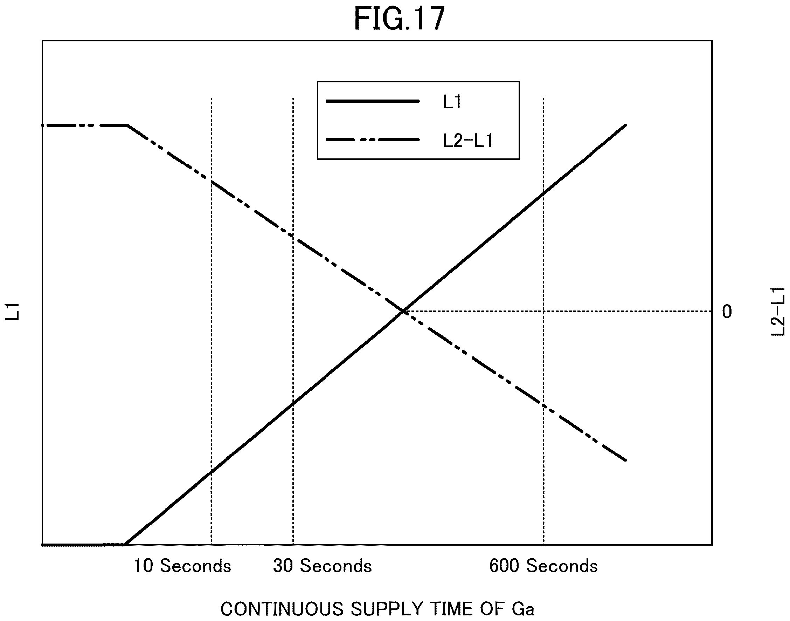

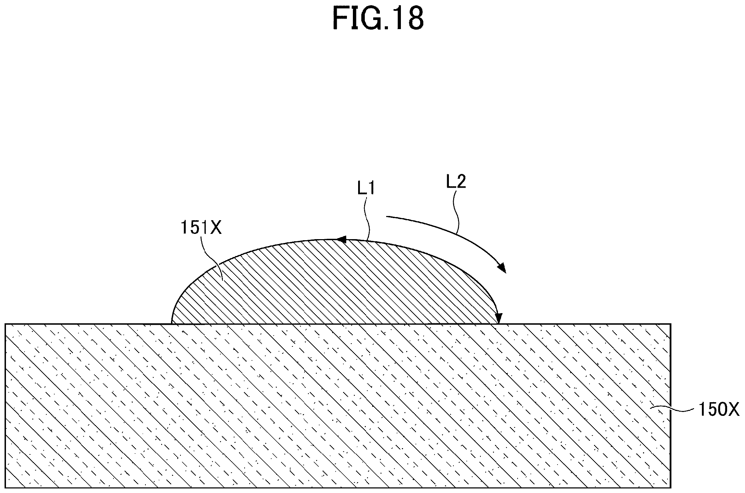

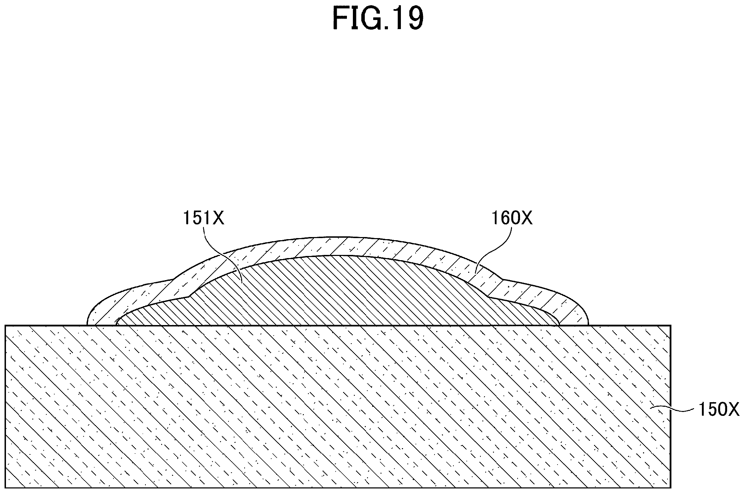

In the case where the time period from the time t1 to the time t2, that is, the continuous supply time of Ga, is too long, large droplets 151 are formed. FIG. 17 is a diagram illustrating a relationship between the continuous supply time of Ga and a droplet size L1. FIG. 17 also illustrates a relationship between the continuous supply time of Ga and a difference (L2 - L1) between a migration length L2 and the droplet size L1 (L2 - L1). In FIG. 17, the abscissa represents the continuous supply time of Ga, the left ordinate represents L1, and the right ordinate represents L2 - L1. FIG. 18 and FIG. 19 are cross sectional views illustrating a phenomenon in a case where the continuous supply time of Ga is too long.

As described above, the n-type GaN layer 160 is formed through migration of the Ga atoms in the droplets 151. The migration length L2 is approximately 1 µm or greater and approximately 3 µm or less, although dependent on conditions, such as the temperature, the pressure, or the like during the time period from the time t2 to the time t1. The migration length L2 is defined as a moving distance of the Ga atom from a start of movement to deactivation. In addition, the droplet size L1 is defined as a length of a shortest path from a top of the surface of the droplet to the front surface of the n-type GaN layer when the droplet is approximated by an ellipsoid.

In a case where the continuous supply time of Ga is too long, a thick n-type GaN layer 150X is formed instead of the n-type GaN layer 150, and a large droplet 151X of the alloy of Ga and Ge is formed on the front surface of the n-type GaN layer 150X, as illustrated in FIG. 18. In this case, the droplet size L1 may become larger than the migration length L2 (L2 - L1 < 0). In a case where the droplet size L1 is larger than the migration length L2, nitridation occurs before the Ga atoms in the droplet 151X spread on the front surface of the n-type GaN layer 150X, and as illustrated in FIG. 19, the surface of the droplet 151X is covered with an n-type GaN layer 160X before the droplet 151X disappears. When the surface of the droplet 151X is covered with the n-type GaN layer 160X, it is difficult to obtain a good flatness. For example, when the time period from the time t1 to the time t2 is approximately 600 seconds, the droplet size L1 becomes approximately 3.5 µm, and the surface of the droplet 151X may become covered with the n-type GaN layer 160X.

On the other hand, when the time period from the time t1 to the time t2 is 10 seconds or longer and 30 seconds or shorter, the droplet size L1 becomes approximately 0.15 µm, the droplet size L1 becomes smaller than the migration length L2 (L2 - L1 > 0), and a good n-type GaN layer 160 can be formed.

### (Second Embodiment)

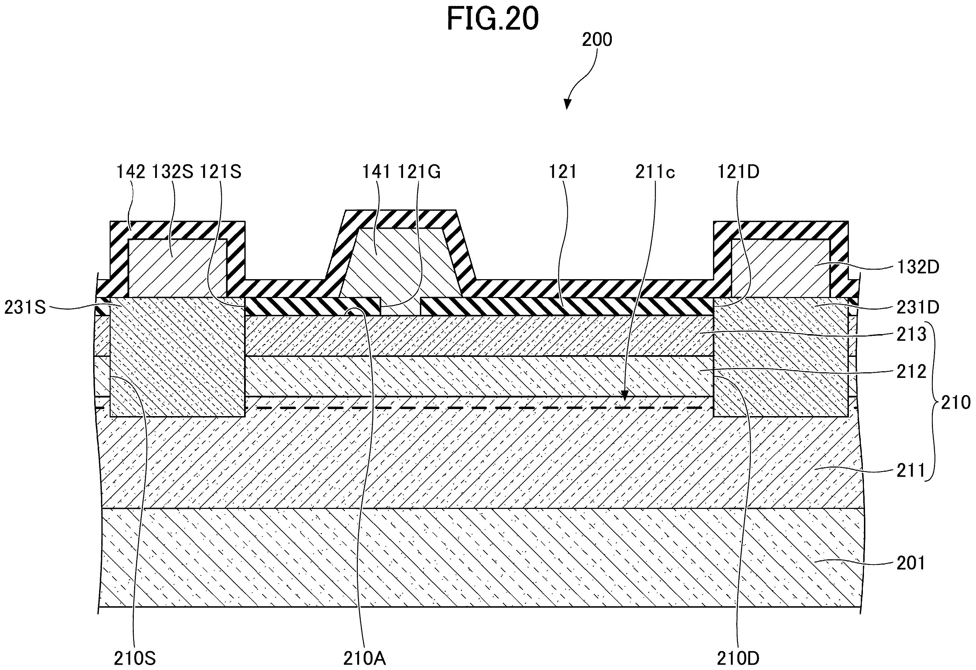

Next, a second embodiment will be described. The second embodiment relates to a semiconductor device including a GaN-based HEMT. FIG. 20 is a cross sectional view illustrating the semiconductor device according to the second embodiment.

As illustrated in FIG. 20, a semiconductor device 200 according to the second embodiment mainly includes a substrate 201, a nitride semiconductor layer 210, an insulating layer 121, an n-type GaN layer 231S, an n-type GaN layer 231D, a gate electrode 141, a source electrode 132S, a drain electrode 132D, and an insulating layer 142.

The substrate 201 is a substrate for growing a GaN-based semiconductor, for example, and is a semiinsulating SiC substrate, for example. In a case where the substrate 201 is the SiC substrate, a front surface of the substrate 201 is a silicon (Si) polar surface. In the case where the front surface of the substrate 201 is the Si polar surface, the nitride semiconductor layer 210 can undergo crystal growth using a Ga polar surface as a growth surface.

The nitride semiconductor layer 210 includes a channel layer 211, a barrier layer 212, and a cap layer 213. The nitride semiconductor layer 210 is an example of the first nitride semiconductor layer.

The channel layer 211 is a GaN layer, for example. A thickness of the channel layer 211 is in a range of 200 nm or greater and 2000 nm or less, for example, and is 1000 nm in one embodiment. A buffer layer may be provided between the channel layer 211 and the substrate 201.

The barrier layer 212 is an AlGaN layer, for example. A band gap of the barrier layer 212 is larger than a band gap of the channel layer 211. A thickness of the barrier layer 212 is in a range of 5 nm or greater and 30 nm or less, for example, and is 15 nm in one embodiment. In a case where the barrier layer 212 is a AlₓGa₁₋ₓN layer, an Al composition x thereof is 0.15 or greater and 0.35 or less, for example, and is 0.25 in one embodiment. A strain is generated between the channel layer 211 and the barrier layer 212 due to a difference in lattice constants thereof, and this strain induces a piezoelectric charge at an interface between the two layers. Hence, a 2DEG is generated in a region of the channel layer 211 closer to the barrier layer 212, thereby forming a channel region 211c. An InAlN layer or an InAlGaN layer may be used in place of the AlGaN layer. In addition, a spacer layer may be provided between the channel layer 211 and the barrier layer 212. The spacer layer is an AlN layer, for example. A thickness of the spacer layer is in a range of 0.5 nm or greater and 3.0 nm or less, for example, and is 1.0 nm in one embodiment.

The cap layer 213 is a GaN layer, for example. A thickness of the cap layer 213 is in a range of 0 nm or greater and 5 nm or less, for example, and is 2 nm in one embodiment. A front surface of the cap layer 213 constitutes a front surface 210A of the nitride semiconductor layer 210.

On the Si polar surface of the SiC substrate, the channel layer 211, the barrier layer 212, and the cap layer 213 undergo crystal growth using the Ga polar surface as the growth surface. Accordingly, front surfaces of the channel layer 211, the barrier layer 212, and the cap layer 213 opposite to back surfaces thereof facing the substrate 201 become Ga polar surfaces, and the back surfaces thereof facing the substrate 201 become N polar surfaces.

Recesses 210S and 210D are formed in the nitride semiconductor layer 210. The recesses 210S and 210D are formed to a depth penetrating the channel region 211c. That is, depths of the recesses 210S and 210D are greater than a depth of the channel region 211c with reference to the front surface 210A of the nitride semiconductor layer 210. Bottom surfaces of the recesses 210S and 210D may be located inside the barrier layer 212.

The insulating layer 121 is in contact with the front surface 210A of the nitride semiconductor layer 210. Openings 121S and 121D are formed in the insulating layer 121. The opening 121S connects to the recess 210S, and the opening 121D connects to the recess 210D.

The n-type GaN layer 231S is formed on the nitride semiconductor layer 210 inside the recess 210S and the opening 121S. The n-type GaN layer 231D is formed on the nitride semiconductor layer 210 inside the recess 210D and the opening 121D. The n-type GaN layers 231S and 231D include Ge or Si as the n-type impurity. The n-type GaN layers 231S and 231D are examples of the second nitride semiconductor layer.

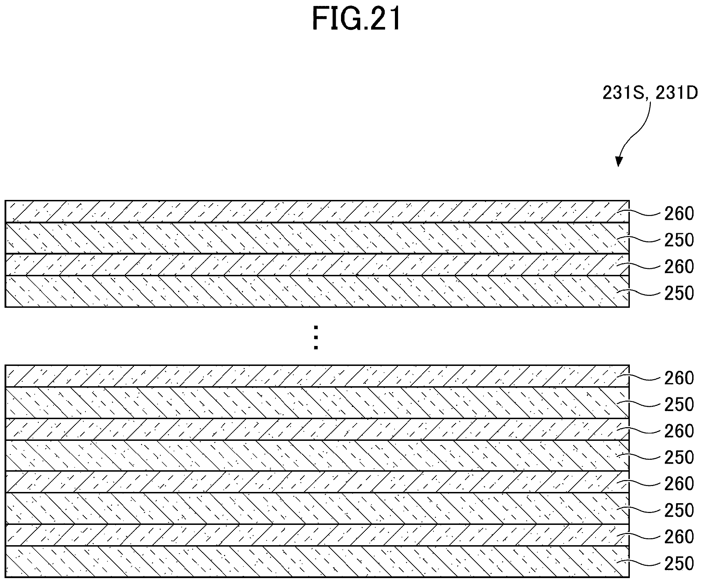

Next, the n-type GaN layers 231S and 231D will be described in detail. FIG. 21 is a cross sectional view illustrating the n-type GaN layers 231S and 231D in the second embodiment.

As illustrated in FIG. 21, the n-type GaN layers 231S and 231D include a plurality of n-type GaN layers 250 and a plurality of n-type GaN layers 260. The n-type GaN layers 250 and 260 are alternately laminated on the nitride semiconductor layer 210. For example, the n-type GaN layers 250 and 260 are laminated on the nitride semiconductor layer 210 with a period of 8 nm or less. The n-type GaN layer 250 includes an n-type impurity with a first concentration of 1 × 10²⁰ cm⁻³ or higher. The n-type GaN layer 250 includes the n-type impurity with the first concentration of 3 × 10²⁰ cm⁻³, and the n-type GaN layer 260 includes an n-type impurity with a second concentration higher than the first concentration, such as 9 × 10²⁰ cm⁻³, for example. In this example, a difference between the first concentration and the second concentration is 6 × 10²⁰ cm⁻³. For this reason, in the n-type GaN layers 231S and 231D, the impurity concentration periodically varies in the depth direction. The n-type GaN layer 250 is an example of the third nitride semiconductor layer, and the n-type GaN layer 260 is an example of the fourth nitride semiconductor layer.

As illustrated in FIG. 20, the source electrode 132S is formed on the n-type GaN layer 231S, and the drain electrode 132D is formed on the n-type GaN layer 231D.

An opening 121G is formed in the insulating layer 121 between the source electrode 132S and the drain electrode 132D. A portion of the nitride semiconductor layer 210 is exposed via the opening 121G. The gate electrode 141 is formed on the insulating layer 121 so as to make contact with the nitride semiconductors 210 via the opening 121G.

Other configurations are the same as those of the first embodiment.

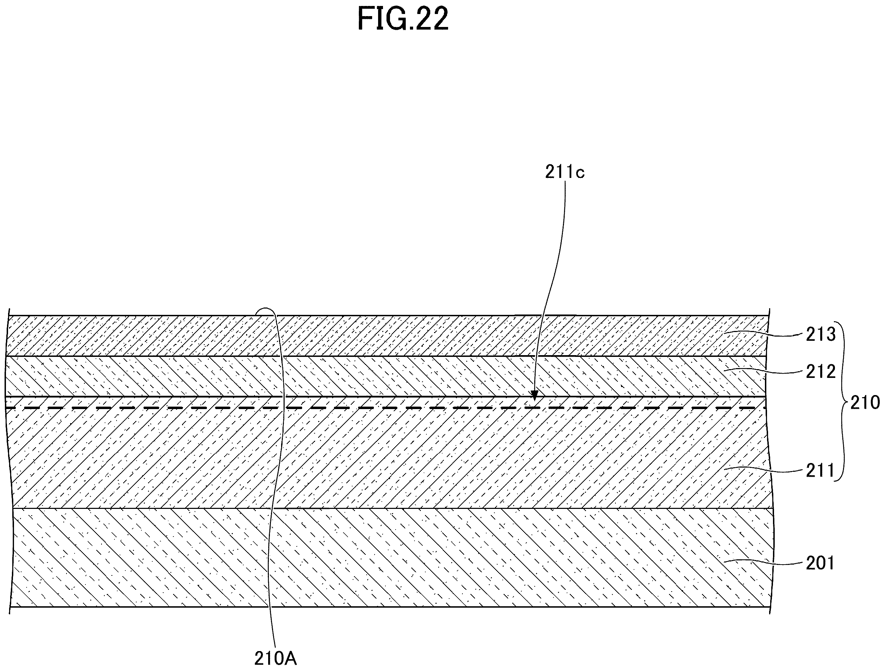

Next, a method for manufacturing the semiconductor device 200 according to the second embodiment will be described. FIG. 22 through FIG. 27 are cross sectional views illustrating the method for manufacturing the semiconductor device according to the

### second embodiment.

First, as illustrated in FIG. 22, the nitride semiconductor layer 210 is formed on the substrate 201 by MOCVD, for example. When forming the nitride semiconductor layer 210, the channel layer 211, the barrier layer 212, and the cap layer 213 are formed in this order. A strain is generated between the channel layer 211 and the barrier layer 212 due to the difference in lattice constant thereof, and this strain induces a piezoelectric charge at the interface between the two layers. Hence, a 2DEG is formed in a region of the channel layer 211 closer to the barrier layer 212, thereby forming the channel region 211c.

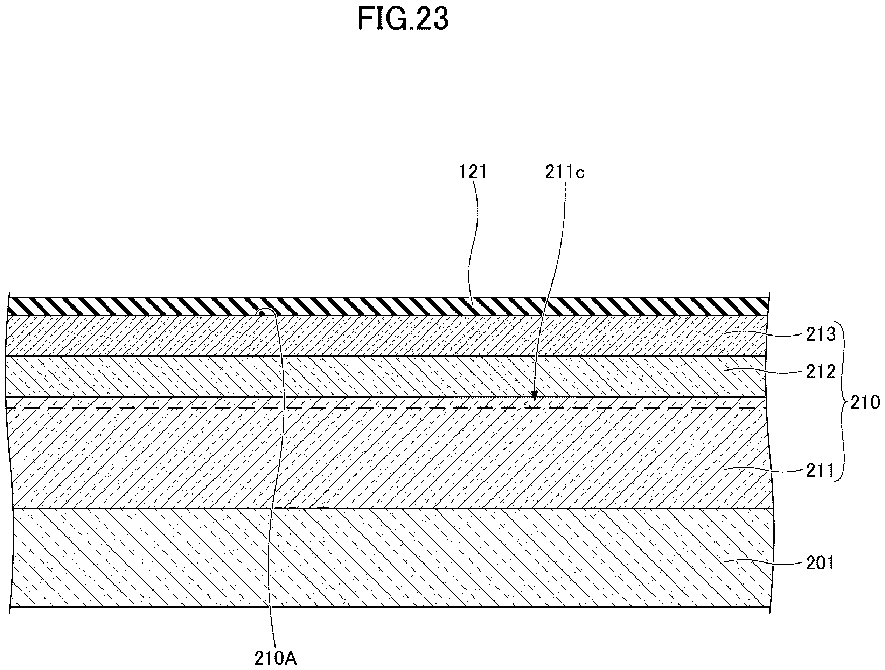

Next, as illustrated in FIG. 23, the insulating layer 121, in contact with the front surface 210A of the nitride semiconductor layer 210, is formed. The insulating layer 121 can be formed by low pressure CVD, for example. The insulating layer 121 may be formed continuously on the channel layer 211, the barrier layer 212, and the cap layer 213 by MOCVD, for example, without exposing the front surface of the cap layer 213 to the atmosphere.

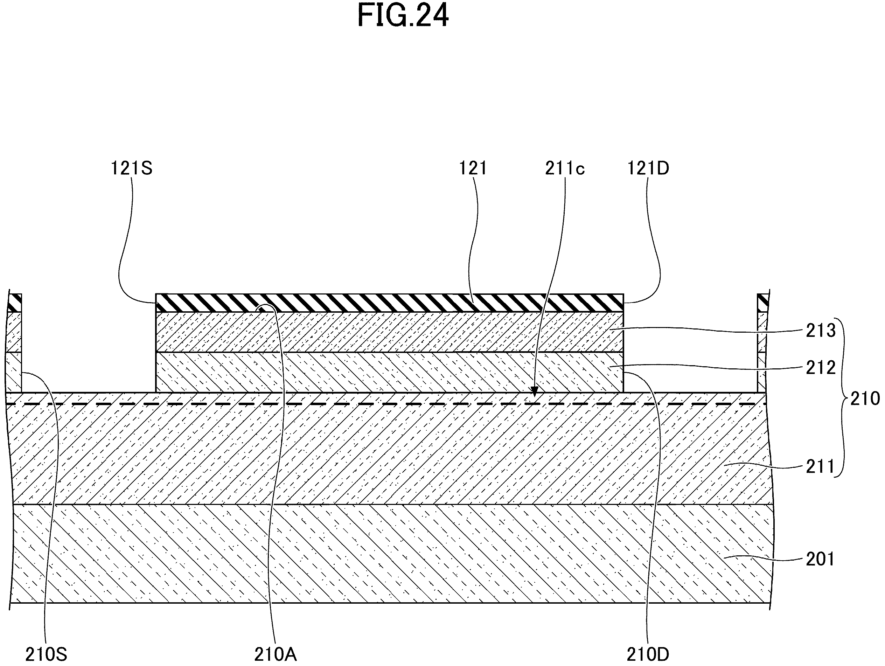

Next, as illustrated in FIG. 24, the openings 121S and 121D are formed in the insulating layer 121, and the recesses 210S and 210D are formed in the nitride semiconductor layer 210. The openings 121S and 121D and the recesses 210S and 210D can be formed by RIE using resist patterns (not illustrated) as masks, for example. For example, a fluorine-based gas is used as a reactive gas in the RIE of the insulating layer 121, and a chlorine-based gas is used as a reactive gas in the RIE of the nitride semiconductor layer 210.

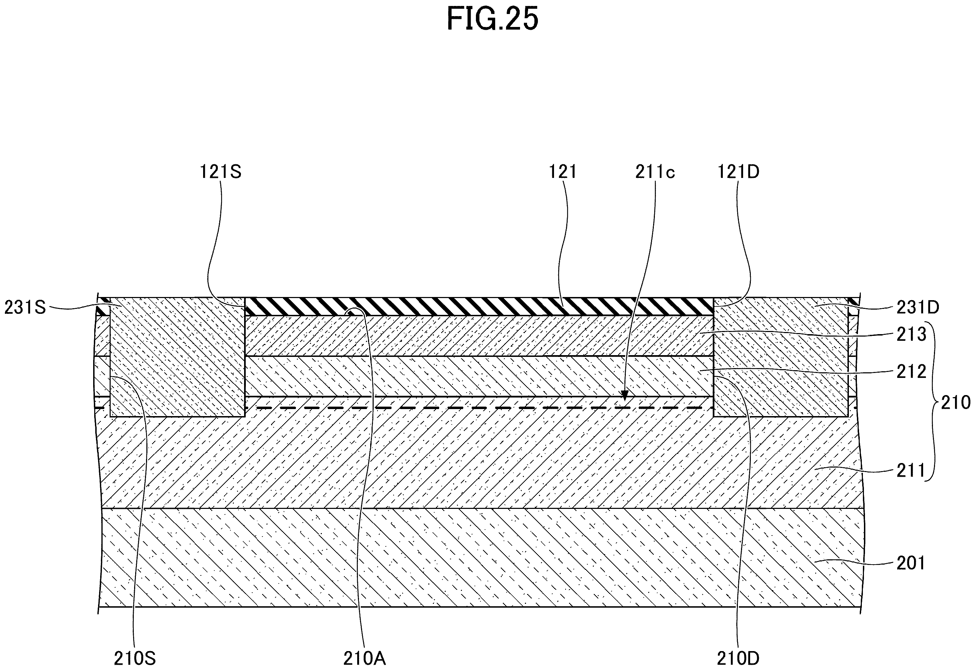

Next, as illustrated in FIG. 25, the n-type GaN layer 231S is formed on the nitride semiconductor layer 210 inside the opening 121S and the recess 210S, and the n-type GaN layer 231D is formed on the nitride semiconductor layer 210 inside the opening 121D and the recess 210D. The upper surfaces of the n-type GaN layers 231S and 231D may coincide with the upper surface of the insulating layer 121, or may not coincide with the upper surface of the insulating layer 121. The n-type GaN layers 231S and 231D can be formed by the same method as that used to form the n-type GaN layers 131S and 131D. Each of the n-type GaN layers 250 and 260 may make direct contact with the nitride semiconductor layer 110, for example.

Although the droplets of the alloy of Ga and Ge are formed also when forming the n-type GaN layers 231S and 231D, the density and size of the droplets in the present embodiment are different from those of the first embodiment because the growth surface in the present embodiment is different from that in the first embodiment. For example, the number density of the droplets is approximately 1.0 × 10⁷ cm⁻², the average diameter of the droplets is approximately 60 nm or greater and 100 nm or less, and the height of the droplets is approximately 20 nm.

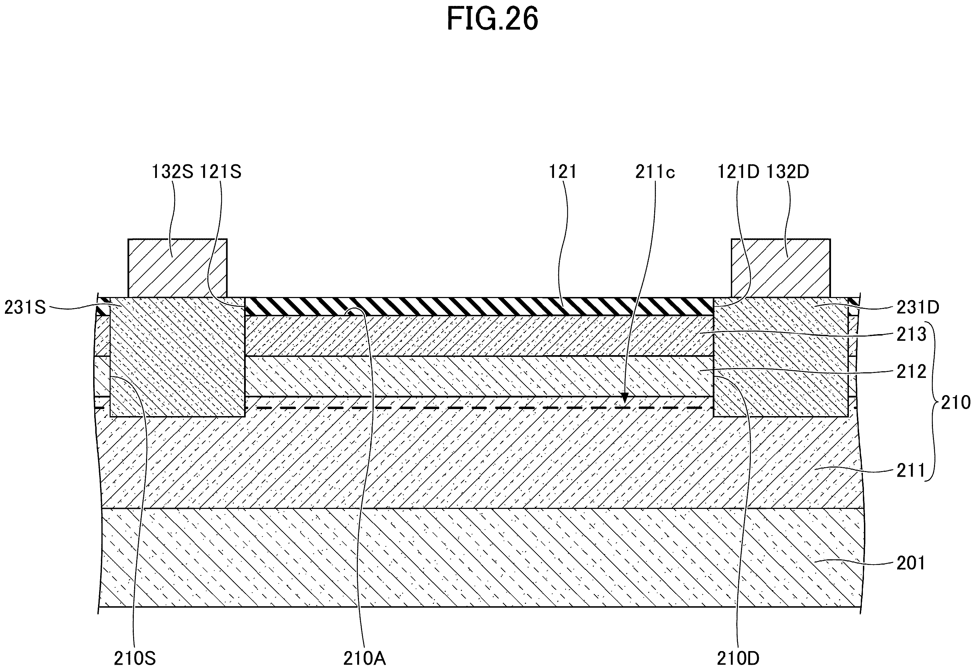

Next, as illustrated in FIG. 26, the source electrode 132S is formed on the n-type GaN layer 131S, and the drain electrode 132D is formed on the n-type GaN layer 131D. The source electrode 132S and the drain electrode 132D can be formed by the same method as that used in the first embodiment.

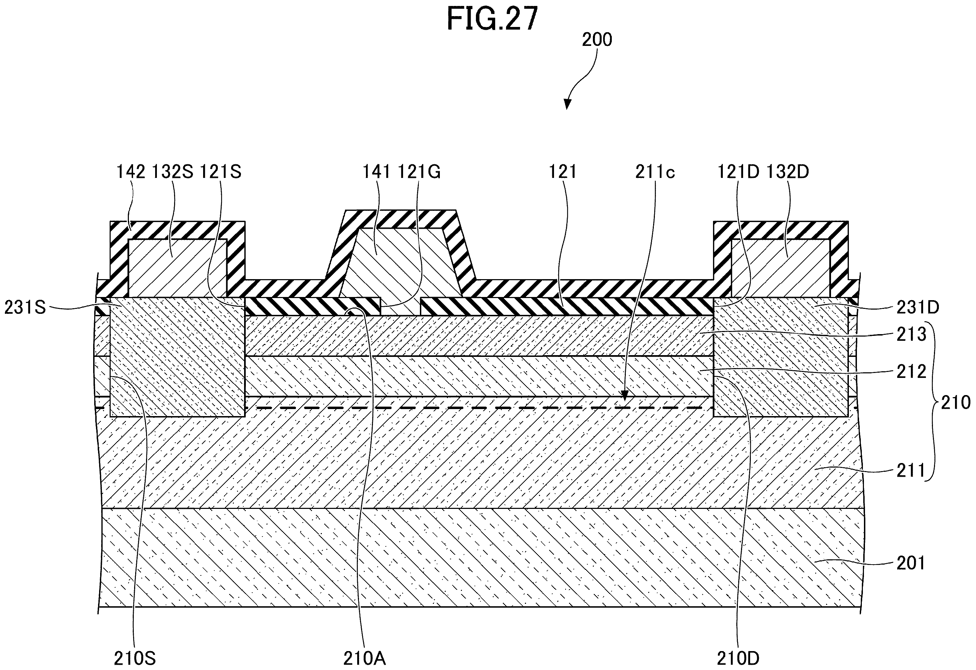

Next, as illustrated in FIG. 27, the opening 121G is formed in the insulating layer 121 between the source electrode 132S and the drain electrode 132D. A portion of the nitride semiconductor layer 210 is exposed via the opening 121G. Next, the gate electrode 141, in contact with the nitride semiconductor layer 210 via the opening 121G, is formed. The gate electrode 141 can be formed by the same method as that used in the first embodiment.

The semiconductor device 200 can be manufactured in the manner described above.

In the semiconductor device 200 according to the second embodiment, the n-type GaN layer 250 includes the n-type impurity such as Ge or the like with the first concentration of 1 × 10²⁰ cm⁻³ or higher, and the n-type GaN layer 260 includes the n-type impurity such as Ge or the like with the second concentration higher than the first concentration. Accordingly, the electrical resistance of the n-type GaN layers 231S and 231D can be sufficiently reduced.

In addition, because the n-type GaN layers 250 and 260 having the different concentrations of the n-type impurity are alternately laminated, a good crystallinity can be obtained although the n-type impurity concentration is high. Moreover, the n-type GaN layers 250 and 260 can be formed by PVD at a temperature at which a damage to the nitride semiconductor layer 210 formed before the formation of these two layers is suppressed. That is, the n-type GaN layers 250 and 260 having a good crystallinity can be formed using an existing film forming apparatus. By lowering the formation temperature of the n-type GaN layers 250 and 260, the effects of improving the throughput and reducing the greenhouse gas emissions can also be obtained.

In the second embodiment, the surface of the nitride semiconductor layer 210 in contact with the lower surfaces of the n-type GaN layers 231S and 231D are Ga polar surfaces, and the barrier layer 212 is located above the channel layer 211. For this reason, the nitride semiconductor layer 210 can easily be grown, and the upper surface of the nitride semiconductor layer 210 can easily exhibit a good etching resistance. In addition, because the n-type GaN layers 231S and 231D are formed inside the recesses 210S and 210D formed in the nitride semiconductor layer 210, respectively, the distances between the channel region 211c and the n-type GaN layers 231S and 231D can easily be reduced, and the resistance can easily be reduced.

Although the embodiments are described above in detail, the present disclosure is not limited to a specific embodiment, and various variations and modifications can be made without departing from the scope described in the claims.

### DESCRIPTION OF REFERENCE NUMERALS

100, 200: semiconductor device
101, 201: substrate
110, 210: nitride semiconductor layer
110A, 210A: front surface
111: buffer layer
112, 212: barrier layer
113, 211: channel layer
113c, 211c: channel region
121, 142: insulating layer
121D, 121G, 121S: opening
131D, 131S, 150, 150X, 160, 160X, 231D, 231S, 250, 260: n-type GaN layer
132D: drain electrode
132S: source electrode
141: gate electrode
151, 151X: droplet
152: N radicals
153: gas Ga
210D, 210S: recess
213: cap layer

## Claims

1. A semiconductor device comprising:
a first nitride semiconductor layer including gallium; and
a second nitride semiconductor layer formed on the first nitride semiconductor layer and including gallium, wherein:
the second nitride semiconductor layer includes a plurality of third nitride semiconductor layers and a plurality of fourth nitride semiconductor layers alternately laminated on the first nitride semiconductor layer,
the plurality of third nitride semiconductor layers include an impurity of a first conductivity type with a first concentration,
the plurality of fourth nitride semiconductor layers include the impurity of the first conductivity type with a second concentration higher than the first concentration, and
the first concentration is 1 × 10²⁰ cm⁻³ or higher.

2. The semiconductor device as claimed in claim 1, wherein the plurality of third nitride semiconductor layers and the plurality of fourth nitride semiconductor layers are laminated with a period of 8 nm or less.

3. The semiconductor device as claimed in claim 1 or 2, wherein a difference between the first concentration and the second concentration is 1 × 10²⁰ cm⁻³ or higher and 7 × 10²⁰ cm⁻³ or lower.

4. The semiconductor device as claimed in any one of claims 1 to 3, wherein the impurity is germanium or silicon.

5. The semiconductor device as claimed in any one of claims 1 to 4, further comprising:
an ohmic electrode formed on the second nitride semiconductor layer.

6. The semiconductor device as claimed in any one of claims 1 to 5, wherein a surface of the first nitride semiconductor layer in contact with a lower surface of the second nitride semiconductor layer is a nitrogen polar surface.

7. The semiconductor device as claimed in claim 6, wherein the first nitride semiconductor layer includes:
a barrier layer; and
a channel layer provided above the barrier layer.

8. The semiconductor device as claimed in claim 6 or 7, further comprising:
an insulating layer formed on the first nitride semiconductor layer, wherein:
the insulating layer includes an opening exposing the first nitride semiconductor layer, and
the second nitride semiconductor layer is formed inside the opening.

9. The semiconductor device as claimed in any one of claims 1 to 5, wherein a surface of the first nitride semiconductor layer in contact with a lower surface of the second nitride semiconductor layer is a gallium polar surface.

10. The semiconductor device as claimed in claim 9, wherein the first nitride semiconductor layer includes:
a channel layer; and
a barrier layer provided above the channel layer.

11. The semiconductor device as claimed in claim 9 or 10, wherein:
the first nitride semiconductor layer is formed with a recess, and
the second nitride semiconductor layer is formed inside the recess.

12. A method for manufacturing a semiconductor device, comprising the steps of:
forming, on a first nitride semiconductor layer including gallium, a second nitride semiconductor layer including gallium by physical vapor deposition,
wherein the step of forming the second nitride semiconductor layer includes repeating the steps of:
forming a third nitride semiconductor layer including an impurity of a first conductivity type with a first concentration, and forming droplets of an alloy of gallium and the impurity on a surface of the third nitride semiconductor layer; and
forming a fourth nitride semiconductor layer including the impurity of the first conductivity type with a second concentration higher than the first concentration, by evaporating a portion of the gallium from the droplets and nitriding another portion of the gallium in the droplets while incorporating the impurity in the droplet.

13. The method for manufacturing the semiconductor device as claimed in claim 12, wherein the step of forming the fourth nitride semiconductor layer eliminates the droplets.

14. The method for manufacturing the semiconductor device as claimed in claim 12 or 13, wherein a duration of the step of forming the fourth nitride semiconductor layer is longer than a duration of the step of forming the third nitride semiconductor layer.

15. The method for manufacturing the semiconductor device as claimed in any one of claims 12 to 14, wherein:
the third nitride semiconductor layer and the fourth nitride semiconductor layer are formed inside a chamber, and
in the steps of forming of the third nitride semiconductor layer and forming of the fourth nitride semiconductor layer, a saturation vapor pressure of gallium is lower than a pressure inside the chamber at a temperature inside the chamber.

16. The method for manufacturing the semiconductor device as claimed in any one of claims 12 to 15, wherein:
the first nitride semiconductor layer is formed on a substrate, and
a temperature of the substrate when forming the third nitride semiconductor layer and the fourth nitride semiconductor layer is 200°C or higher and 650°C or lower.
